# EUROPÄISCHE PATENTSCHRIFT

(11) **EP 0 496 018 B1**
(45) Veröffentlichungstag und Bekanntmachung des Hinweises auf die Patenterteilung: **27.03.1996**
(21) Anmeldenummer: 91100851.4
(22) Anmeldetag: 23.01.1991
(51) Int. Cl.: H03K 17/22

(54) **Integrierte Schaltung zur Erzeugung eines Reset-Signals**
Integrated circuit for generating a reset signal
Circuit intégré servant à générer un signal de remise à zéro

(43) Veröffentlichungstag der Anmeldung: 29.07.1992
(73) Patentinhaber: SIEMENS AKTIENGESELLSCHAFT, D-80333 München (DE)
(72) Erfinder: Savagnac, Dominique, Dr., W-8045 Ismaning (DE); Gleis, Dieter, Dr., W-8201 Grosskarolinenfeld (DE); Murphy, Brian, Dr., W-8000 München 19 (DE)

(56) Entgegenhaltungen:
- PATENT ABSTRACTS OF JAPAN, Band 12, Nr. 65 (E-586)[2912], 27. Februar 1988; & JP-A-62 209 920 (FUJITSU LTD) 16-09-1987
- TOUTE L'ELECTRONIQUE, Nr. 454, Mai 1980, Seiten 91-94; "Triggers de Schmitt C- MOS"
- ELECTRONIC DESIGN, Band 34, Nr. 9, 17. April 1986, Seiten 77,78,80,82,84; R. BERNHARD: "Advanced CMOS logic presents stiff competition for Schottky"
- RESEARCH DISCLOSURE, Nr. 277, Mai 1987, Seite 317; "CMOS on-chip VVD lock-out pulse"

## Beschreibung

### Integrierte Schaltung zur Erzeugung eines Reset-Signals.

Die Erfindung betrifft eine integrierte Schaltung zur Erzeugung eines Reset-Signals gemäß dem Oberbegriff des Anspruchs 1.

Eine gattungsgemäße Schaltung ist aus Patent Abstracts of Japan, Band 12, Nr. 65 (E-586) (2912), 27. Februar 1988 bekannt.

Beim Einschalten der Versorgungsspannung komplexer Schaltungen, insbesondere komplexer integrierter Schaltungen, besteht die Gefahr, daß einzelne Schaltungsteile einen undefinierten Zustand einnehmen. Undefinierte Zustände haben jedoch im allgemeinen Fehlfunktionen zur Folge bis hin zu Schäden an diesen Schaltungen oder an elektrischen Komponenten, die mit diesen Schaltungen verbunden sind.

Um besagte Fehlfunktionen ausschließen zu können, ist deshalb häufig eine sogenannte "Power-on-Resetschaltung" vorgesehen, die bei Anlegen der Versorgungsspannung einen meist einzelnen Signalimpuls (sog. Reset-Signal) erzeugt, der bezüglich des Einschaltens der Versorgungsspannung kritische Schaltungen oder Schaltungsteile gezielt in einen definierten Ausgangszustand versetzen soll, um so die obengenannten Nachteile zu vermeiden.

Aufgabe der vorliegenden Erfindung ist es, eine integrierte Schaltung zu schaffen zur Erzeugung eines Reset-Signals bei Anlegen der Versorgungsspannung, die folgende Vorgaben sicher erfüllt:
- Der elektrisch aktive Teil des Reset-Signals soll eine Mindestdauer aufweisen, die sowohl bei schneller wie auch bei langsamer Anstiegszeit der Versorungsspannung sicher eingehalten wird,
- die Mindestdauer soll auch dann eingehalten werden, wenn der volle Wert der Versorgungsspannung bezüglich der vom Hersteller der komplexen Schaltung vorgegebenen Grenzwerte der Versorgungsspannung unter- oder überschritten wird,
- im Falle von Spannungsschwankungen der Versorgungsspannung im Betrieb, d.h. nach Anlegen der Versorgungsspannung und daraufhin bereits erfolgtem Reset-Vorgang, soll ein erneutes Aktivieren des Reset-Signals sicher verhindert werden,
- die Schaltung soll möglichst wenig Schaltelemente und einen möglichst geringen Platzbedarf aufweisen.

Diese Aufgabe wird gelöst mit einer integrierten Schaltung, die die Merkmale des Patentanspruches 1 aufweist.

Vorteilhafte Aus- und Weiterbildungen sind in abhängigen Ansprüchen gekennzeichnet.

Nachstehend wird die Erfindung anhand der Zeichnung näher erläutert. Es zeigen:
- Figuren 1,2:: Vorteilhafte Ausgestaltungen der Erfindung,
- Figur 3:: Ein Timingdiagramm bezüglich der Ausführung nach Figur 1.

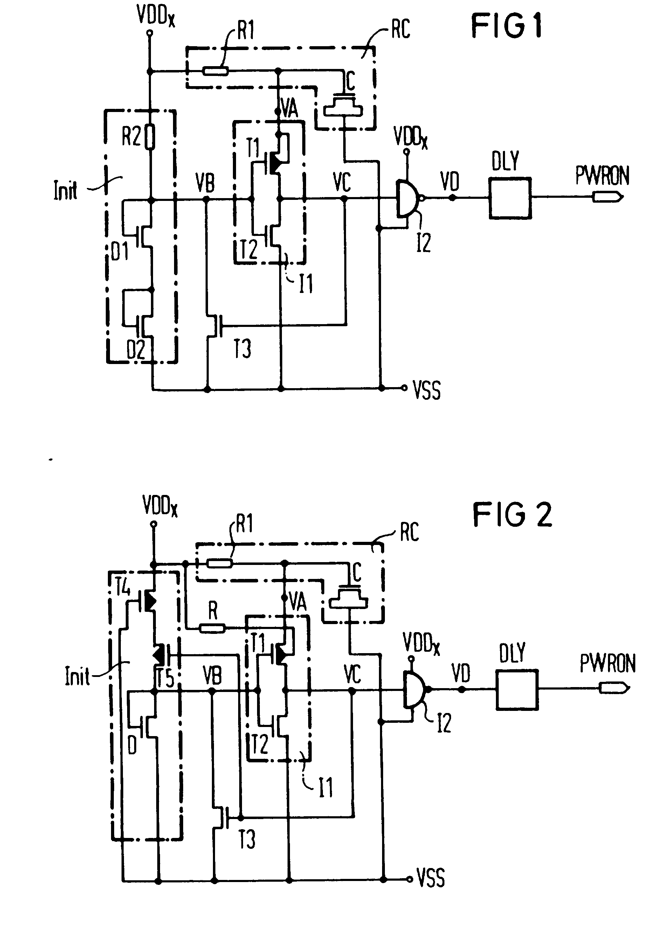

Die Ausführungsform nach Figur 1 zeigt eine erfindungsgemäße integrierte Schaltung mit Anschlüssen für ein erstes (VDDₓ) und ein zweites Versorgungspotential VSS. Das erste Versorgungspotential VDDₓ weist im allgemeinen im Betrieb, d.h. nach dem Anschalten der Versorgungsspannung VDDₓ-VSS, meist einen Wert von VDD = 5 V ± 10% auf. Das zweite Versorgungspotential wird meist mit Masse bezeichnet, d.h. 0 V. Andere Werte der Versorgungspotentiale VDDₓ,VSS sind selbstverständlich vorstellbar unter entsprechender, dem Fachmann geläufiger Anpassung der Dimensionierung und ggf. der Polarisierung (z.B. Verwendung von n-Kanal-Transistoren anstelle von p-Kanal-Transistoren und umgekehrt).

Zwischen den Anschlüssen für die Versorgungspotentiale VDDₓ,VSS ist ein seriales RC-Netzwerk RC angeordnet, dargestellt als Reihenschaltung eines ohm'schen Widerstandes R1 und eines als Kapazität C wirkenden MOS-Transistors (d.h. dessen Drain und Source sind miteinander kurzgeschlossen). Die Kapazität C ist selbstverständlich auch als üblicher Kondensator realisierbar. Der Verbindungspunkt zwischen dem ohm'schen Widerstand R1 und der Kapazität C bildet einen ersten Schaltungsknoten VA.

Dem RC-Netzwerk RC ist eine Initialisierungsschaltung Init elektrisch parallelgeschaltet mit einem Ausgang, der ein zweiter Schaltungsknoten VB der Gesamtschaltung ist. Die Initialisierungsschaltung Init enthält einen ohm'schen Widerstand R2, der zwischen dem Anschluß für das erste Versorgungspotential VDDₓ und dem zweiten Schaltungsknoten VB angeordnet ist. Sie enthält weiterhin zwei als Dioden D1,D2 geschaltete n-Kanal-Transistoren, die, in Serie zueinander, zwischen dem zweiten Schaltungsknoten VB und dem Anschluß für das zweite Versorgungspotential VSS angeordnet sind. Die Diodenwirkung wird dadurch erreicht, daß das Gate jedes Transistors mit der jeweils zugehörigen Drain verbunden ist. Insgesamt betrachtet, enthält somit die Initialisierungsschaltung Init nach Figur 1 eine Reihenschaltung des ohm'schen Widerstandes R2 und der beiden Dioden D1,D2. Erfindungsgemäß wird damit erreicht, daß der zweite Schaltungsknoten VB im Betrieb einen maximalen Potentialwert aufweist, der die Summe (zweites Versorgungspotential VSS + Flußspannung der ersten Diode D1 + Flußspannung der zweiten Diode D2) nie überschreitet. Bei angenommenen Werten von zweitem Versorgungspotential VSS = 0 V, Flußspannung der ersten Diode D1 = 1 V, Flußspannung der zweiten Diode D2 = 1.4 V ergibt sich somit ein Maximalwert von 2.4 V am zweiten Schaltungsknoten VB.

Zwischen dem ersten Schaltungsknoten VA und dem Anschluß für das zweite Versorgungspotential VSS ist eine Inverterschaltung I1 angeordnet, dargestellt als CMOS-Inverter mit zwei MOS-Transistoren T1,T2 vom einander jeweils entgegengesetzten Leitungstyp. Der Eingang der Inverterschaltung I1 ist mit dem zweiten Schaltungsknoten VB verbunden. Ihr Ausgang bildet einen dritten Schaltungsknoten VC der Gesamtschaltung.

Zwischen dem zweiten Schaltungsknoten VB und dem Anschluß für das zweite Versorgungspotential VSS ist ein n-Kanal-MOS-Transistor T3 mit seiner Kanalstrecke angeordnet. Sein Gate ist mit dem dritten Schaltungsknoten VC verbunden.

Der dritte Schaltungsknoten VC ist weiterhin Eingang eines Inverters I2, der versorgungsspannungsmäßig mit den Anschlüssen für die beiden Versorgungspotentiale VDDₓ,VSS verbunden ist. Sein Ausgang bildet einen vierten Schaltungsknoten VD der Gesamtschaltung. An ihm entsteht im Betrieb das Reset-Signal der Gesamtschaltung.

In Weiterbildung des Grundgedankens der Erfindung ist dem vierten Schaltungsknoten VD eine Verzögerungsschaltung DLY nachgeordnet. Diese gibt im Betrieb eine auf eine erste Flanke des Reset-Signals nachfolgende zweite Flanke zeitverzögert an ihren Ausgang PWRON weiter. Damit läßt sich die Zeitdauer zwischen den beiden Signalflanken des Reset-Signals vergrößern.

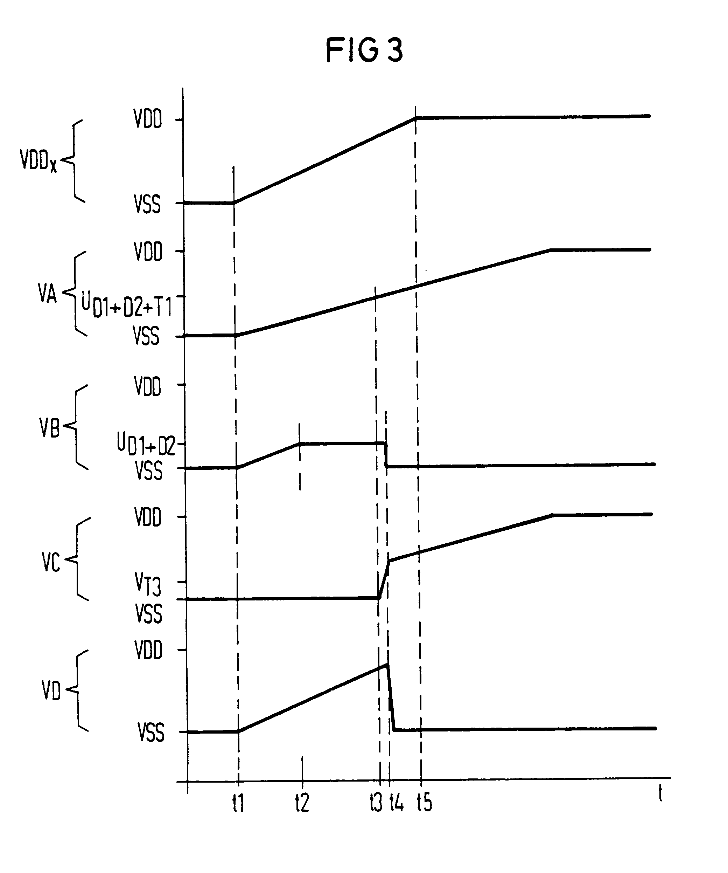

Im folgenden wird nun die Funktion der erfindungsgemäßen Schaltung im Betrieb anhand eines Zeitdiagramms (s. Figur 3) erläutert. Dabei wird angenommen, daß beim Einschalten der Versorgungspotentiale VDDₓ,VSS das erste Versorgungspotential VDDₓ zu einem Zeitpunkt t1 noch einen Wert von 0 V (= zweites Versorgungspotential VSS) aufweist und dann ansteigt bis zu einem Nennwert von VDDₓ = VDD (beispielsweise 5 V) zu einem Zeitpunkt t5. Das zweite Versorgungspotential VSS hat einen Wert von 0 V. Mit Anlegen des Versorgungspotentials VDDₓ steigt auch das Potential am ersten Schaltungsknoten VA an bis auf den Nennwert VDD. Wegen der RC-Wirkung des RC-Netzwerkes RC (Aufladen der kapazitiven Komponente C) erfolgt dieser Anstieg jedoch deutlich langsamer als der des ersten Versorgungspotentials VDDₓ (Zeitverlauf abhängig von der Dimensionierung der ohm'schen Komponente R1 und der kapazitiven Komponente C).

Auch am zweiten Schaltungsknoten VB erfolgt ein Potentialanstieg, der allerdings deutlich schneller abläuft als am ersten Schaltungsknoten VA. Der Potentialanstieg wird durch die beiden Dioden D1,D2 auf den bereits genannten Maximalwert begrenzt, der um die beiden Dioden-Flußspannungen U_{D1},U_{D2} über dem Wert des zweiten Versorgungspotentials VSS liegt (vgl. vorstehendes Zahlenbeispiel; in Figur 3 mit "U_{D1+D2}" bezeichnet). Der Maximalwert wird zu einem Zeitpunkt t2 erreicht und behält dann (bis zu einem Zeitpunkt t4, was noch beschrieben wird) seinen Wert bei.

Wegen der unterschiedlich schnellen Potentialanstiege an den beiden Schaltungsknoten VA,VB (s. oben) ist zum Zeitpunkt t2 das Potential am ersten Schaltungsknoten VA niedriger als das Potential am zweiten Schaltungsknoten VB. Ab dem Zeitpunkt t2 verringert sich wegen der zu diesem Zeitpunkt eintretenden Konstanz des Potentials am zweiten Schaltungsknoten VB die Potentialdifferenz zwischen den beiden Schaltungsknoten VA,VB bis auf Null (Zeitpunkt in Figur 3 nicht dargestellt), anschließend wird das Potential am ersten Schaltungsknoten VA größer als das am zweiten Schaltungsknoten VB.

Zu einem Zeitpunkt t3, bei dem der zweite Schaltungsknoten VB immer noch seinen Maximalwert U_{D1+D2} aufweist, weist das Potential am ersten Schaltungsknoten VA einen Wert von U_{D1+D2} zuzüglich dem Wert der Einsatzspannung V_{T1} des p-Kanal-Transistors T1 des CMOS-Inverters der Inverterschaltung I1 auf (in Figur 3 dargestellt als Wert U_{D1+D2+T1}). Bis zu diesem Zeitpunkt t3 ist der p-Kanal-Transistor T1 gesperrt, während der n-Kanal-Transistor T2 des CMOS-Inverters der Inverterschaltung I1 leitend ist (Potential am zweiten Schaltungsknoten VB ist größer als die Einsatzspannung V_{T2} des n-Kanal-Transistors T2). Demzufolge weist der dritte Schaltungsknoten VC bis zum Zeitpunkt t3 den Wert des zweiten Versorgungspotentials VSS (= 0 V) auf. Dementsprechend weist das Potential am vierten Schaltungsknoten VD (= Ausgang des Inverters I2) im Zeitraum zwischen den Zeitpunkten t1 und t3 den jeweils aktuellen Wert des ersten Versorgungspotentials VDDₓ auf.

Ab dem Zeitpunkt t3 wird das Potential am ersten Schaltungsknoten VA größer als der zuvor bereits genannte Wert U_{D1+D2+T1}, während der zweite Schaltungsknoten VB sein Potential in Höhe von U_{D1+D2} beibehält. Demzufolge wird der p-Kanal-Transistor T1 der Inverterschaltung I1 zunehmend leitend. Damit steigt das Potential am dritten Schaltungsknoten VC an bis zum aktuellen Wert des Potentials am ersten Schaltungsknoten VA. Der vierte Schaltungsknoten VD (= Ausgang des Inverters I2) nimmt somit den Wert des zweiten Versorgungspotentials VSS (= 0 V) an.

Mit Ansteigen des Potentials am dritten Schaltungsknoten VC über den Wert der Einsatzspannung V_{T3} des n-Kanal-Transistors T3 hinaus wird dieser leitend (Zeitpunkt t4) und zieht somit das Potential am zweiten Schaltungsknoten VB auf den Wert des zweiten Versorgungspotentials VSS (= 0 V). Demzufolge sperrt nun der Transistor T2 der Inverterschaltung I1, während der Transistor T1 noch stärker leitend wird.

Das Reset-Signal am vierten Schaltungsknoten VD weist also nach dem Anlegen des ersten Versorgungspotentials VDDₓ folgenden zeitlichen Verlauf auf: Ab dem Zeitpunkt t1 erfolgt ein Ansteigen in Form einer ersten Signalflanke, die dem zeitlichen Verlauf des Wertes des ersten Versorgungspotentials VDDₓ folgt, bis zu einem Zeitpunkt, bei dem das Potential am Eingang des Inverters I2, d.h. also am dritten Schaltungsknoten VC, dem Potential entspricht, bei dem der Inverter I2 umschaltet. Zu diesem Zeitpunkt (nicht dargestellt aus Gründen der Übersichtlichkeit) schaltet der Inverter I2 um, d.h. es schließt sich eine zweite, abfallende Signalflanke an bis zum Wert des zweiten Versorgungspotentials VSS. Die Dauer des Reset-Signals ist also definiert durch die Dauer des Anstieges der ersten Signalflanke zuzüglich der Dauer der zweiten Signalflanke (die durch das Schaltverhalten des Inverters I2 definiert ist).

Um die Dauer des Reset-Signals zu vergrößern, ist es vorteilhaft, dem Inverter I2 noch eine Verzögerungsschaltung DLY nachzuschalten, die die zweite Flanke des Reset-Signals verzögert.

Die Ausgestaltung kann mit dem Fachmann geläufigen Mitteln erfolgen.

Die Erfindung ermöglicht somit eine sichere Erzeugung eines Reset-Signals, die nicht negativ beeinflußt wird durch die Steilheit des Anstiegs des ersten Versorgungspotentials VDDₓ (die je nach Potentialquelle unterschiedlich sein kann). Dies wird dadurch erreicht, daß der erste Schaltungsknoten VA stets einen langsameren Potentialanstieg aufweist als der zweite Schaltungsknoten VB, so daß der dritte Schaltungsknoten VC als Ausgang der Inverterschaltung I1 bis zum Zeitpunkt t3 ständig auf dem Wert des zweiten Versorgungspotentials VSS gehalten wird, weil die Inverterschaltung I1 bis zum Zeitpunkt t3 niemals in ihren zum Ausgangszustand komplementären Zustand schalten kann.

Weiterhin wird durch die erfindungsgemäße Schaltung nach erstmaligem Auftreten des Reset-Signals auch verhindert, daß das Reset-Signal ein weiteres Mal aktiviert wird bei Auftreten von Einbrüchen des ersten Versorgungspotentials VDDₓ bis herunter zu einem Wert von VDDₓ = Einsatzspannung V_{T3} des Transistors T3. Ebenso lassen auch eventuell auftretende Überspannungsimpulse beim ersten Versorgungspotential VDDₓ das Reset-Signal unbeeinflußt.

Nach Auftreten des Reset-Signals fließt zwischen den Anschlüssen für die beiden Versorgungspotentiale VDDₓ,VSS über den Widerstand R2 der Initialisierungsschaltung Init und den (dann leitenden) Transistor T3 stets ein Querstrom, der durch geeignete Dimensionierung des Widerstandes R2 entsprechend gering gehalten werden kann.

Durch eine Ausgestaltung der Initialisierungsschaltung Init gemäß Figur 2 läßt er sich jedoch auch gänzlich eliminieren: Dabei ist der Widerstand R2 durch die Serienschaltung zweier p-Kanal-Transistoren T4,T5 ersetzt. Das Gate des einen Transistors T4 ist mit dem Anschluß für das zweite Versorgungspotential VSS verbunden, wodurch er bei Anliegen des ersten Versorgungspotentials VDDₓ leitend wird. Der Transistor T4 wirkt dann strombegrenzend. Das Gate des anderen Transistors T5 ist mit dem dritten Schaltungsknoten VC verbunden. Damit ist er bis kurz nach dem Zeitpunkt t3 ebenfalls elektrisch leitend, so daß der zweite Schaltungsknoten VB den vorstehend bereits beschriebenen Potentialverlauf annehmen kann. Durch Ansteigen des Potentials am dritten Schaltungsknoten VC ab dem Zeitpunkt t3 (wie ebenfalls bereits beschrieben) sperrt er jedoch ab einem Zeitpunkt, in dem der dritte Schaltungsknoten VC ein Potential aufweist, das höchstens um den Wert der Einsatzspannung des Transistors T5 unter dem aktuellen Wert des ersten Versorgungspotentials VDDₓ liegt. Bei der Ausführungsform nach Figur 2 enthält die Initialisierungsschaltung Init lediglich eine einzelne Diode D. Auch dies ist möglich, wenn man deren Flußspannung entsprechend dem gewünschten Maximalwert am zweiten Schaltungsknoten VB dimensioniert.

Die beiden Transistoren T4,T5 können auch in Serie zum Widerstand R2 geschaltet sein. Weiterhin kann der Transistor T4 bei Verwendung des Widerstandes R2 auch entfallen, da der Widerstand R2 strombegrenzend wirkt. Allerdings werden dann im Betrieb am ersten Versorgungspotential VDDₓ auftretende Potentialschwankungen über die Source-Gate-Kapazität des Transistors T5 direkt auf den dritten Schaltungsknoten VC gekoppelt, so daß bei zu großen Potentialschwankungen das Reset-Signal unerwünschterweise erneut auftritt.

Weiterhin ist es vorteilhaft, das Substrat des Transistors T1 der Inverterschaltung I1 entweder mit dem ersten Schaltungsknoten VA zu verbinden (s. Figur 1) oder hochohmig (s. Figur 2) mit dem Anschluß für das erste Versorgungspotential VDDₓ zu verbinden. Damit ist es im Betrieb ausgeschlossen, daß das erste Versorgungspotential VDDₓ bei auftretenden Potentialschwankungen kurzzeitig unter den Wert des Potentials am ersten Schaltungsknoten VA sinkt (Vermeiden, daß die Source/Drain-Dioden des Transistors T1 in Durchlaßrichtung schalten können).

Die Erfindung wurde vorstehend beschrieben unter der Annahme, daß das erste Versorgungspotential VDDₓ positiver sein soll als das zweite Versorgungspotential VSS. Dem Fachmann ist es jedoch anhand der vorstehenden Beschreibung auch möglich, die erfindungsgemäße Schaltung (insbesondere unter entsprechender Anpassung der Leitfähigkeitstypen der verwendeten Transistoren und Dioden) so abzuändern, daß das erste Versorgungspotential VDDₓ negativer sein kann als das zweite Versorgungspotential VSS.

Ebenso ist der Fachmann auch nicht beschränkt auf den Einsatz von genau zwei Dioden D1,D2 in der Initialisierungsschaltung Init oder auf den Einsatz von genau einem CMOS-Inverter mit den Transistoren T1,T2 der Inverterschaltung I1.

## Patentansprüche

1. Integrierte Schaltung zur Erzeugung eines Reset-Signals mit folgenden Merkmalen:
- Die integrierte Schaltung weist Anschlüsse für ein erstes und ein zweites Versorgungspotential (VDD_{X}, VSS) auf,
- es ist eine Inverterschaltung(I1) vorgesehen, die versorgungsspannungsmäßig zwischen einem ersten Schaltungsknoten (VA) der Gesamtschaltung und dem Anschluß für das zweite Versorgungspotential (VSS) angeordnet ist,
- der Eingang der Inverterschaltung (I1) ist mit einem zweiten Schaltungsknoten (VB) verbunden und ihr Ausgang bildet einen dritten Schaltungsknoten (VC),
- zwischen den Anschlüssen für das erste und das zweite Versorgungspotential (VDD_{X}, VSS) ist eine Initialisierungsschaltung (Init) angeordnet mit einem Ausgang, der den zweiten Schaltungsknoten (VB) bildet und an dem bei Anschalten des ersten Versorgungspotentials (VDD_{X}) ein Potential entsteht, mit einem durch die Dimensionierung der Initialisierungsschaltung (Init) vorgegebenen Maximalwert,
- zwischen dem zweiten Schaltungsknoten (VB) und dem Anschluß für das zweite Versorgungspotential (VSS) ist ein Transistor (T3) eines ersten Leitungstyps mit seiner Source-Drain-Strecke angeordnet, dessen Gate mit dem dritten Schaltungsknoten (VC) verbunden ist,
**dadurch gekennzeichnet,**
daß zwischen den Anschlüssen für das erste und das zweite Versorgungspotential (VDD_{X}, VSS) ein seriales RC-Netzwerk (RC) angeordnet ist, mit einer ohmschen (R1) und einer kapazitiven Komponente (C), zwischen welchen der erste Schaltungsknoten (VA) angeordnet ist, wobei die Spannung an der Kapazitiven Komponente (C) die Versorgungsspannung für die Inverterschaltung (I1) bildet,
und daß der dritte Schaltungsknoten (VC) Eingang eines Inverters (I2) ist, welcher versorgungsspannungsmäßig zwischen den Anschlüssen für das erste und das zweite Versorgungspotential (VDD_{X}, VSS) angeordnet ist und an dessen Ausgang als viertem Schaltungsknoten (VD) der Gesamtschaltung im Betrieb das Reset-Signal entsteht.

2. Integrierte Schaltung nach Anspruch 1, **dadurch gekennzeichnet**, daß dem vierten Schaltungsknoten (VD) eine Verzögerungsschaltung (DLY) nachgeordnet ist, die im Betrieb eine auf eine erste Flanke des Reset-Signals nachfolgende zweite Flanke verzögert an ihren Ausgang (PWRON) gibt.

3. Integrierte Schaltung nach Anspruch 1 oder 2, **dadurch gekennzeichnet,** daß die Initialisierungsschaltung (Init) wenigstens einen ohm'schen Widerstand (R2) enthält, der zwischen dem Anschluß für das erste Versorgungspotential (VDDₓ) und dem zweiten Schaltungsknoten (VB) angeordnet ist.

4. Integrierte Schaltung nach Anspruch 3, **dadurch gekennzeichnet,** daß die Initialisierungsschaltung (Init) einen Transistor (T5) eines zweiten, zum ersten Leitungstyp entgegengesetzten Leitungstyps enthält, der zwischen dem ohm'schen Widerstand (R2) und dem zweiten Schaltungsknoten (VB) angeordnet ist und dessen Gate mit dem dritten Schaltungsknoten (VC) verbunden ist.

5. Integrierte Schaltung nach einem der Ansprüche 1,2 oder 3, **dadurch gekennzeichnet,** daß
- die Initialisierungsschaltung (Init) zwei mit ihren Source-Drain-Strecken in Serie zueinander geschaltete Transistoren (T4,T5) eines zweiten, zum ersten Leitungstyp entgegengesetzten Leitungstyps enthält, die zwischen dem Anschluß für das erste Versorgungspotential (VDDₓ) und dem zweiten Schaltungsknoten (VB) angeordnet sind, gegebenenfalls in Serie zum ohm'schen Widerstand (R2),
- das Gate des einen (T4) der in Serie geschalteten Transistoren (T4,T5) ist mit dem Anschluß für das zweite Versorgungspotential (VSS) verbunden,
- das Gate des anderen (T5) der in Serie geschalteten Transistoren (T4,T5) ist mit dem dritten Schaltungsknoten (VC) verbunden.

6. Integrierte Schaltung nach einem der vorhergehenden Ansprüche, **dadurch gekennzeichnet,** daß die Initialisierungsschaltung (Init) eine (D) oder wenigstens zwei in Serie zueinander geschaltete (D1,D2) Dioden enthält, die zwischen dem zweiten Schaltungsknoten (VB) und dem Anschluß für das zweite Versorgungspotential (VSS) angeordnet ist/sind.

7. Integrierte Schaltung nach Anspruch 6, **dadurch gekennzeichnet,** daß die Dioden (D;D1,D2) MOS-Transistoren sind, deren Gates mit der jeweils zugehörigen Drain verbunden sind.

8. Integrierte Schaltung nach einem der vorhergehenden Ansprüche, **dadurch gekennzeichnet,** daß die Inverterschaltung (I1) wenigstens einen CMOS-Inverter (T1+T2) mit einem p-Kanal-Transistor (T1) und mit einem n-Kanal-Transistor (T2) enthält.

9. Integrierte Schaltung nach Ansprch 8, **dadurch gekennzeichnet,** daß das Substrat des p-Kanal-Transistors (T1) entweder mit dem ersten Schaltungsknoten (VA) oder hochohmig (R) mit dem Anschluß für das erste Versorgungspotential (VDDₓ) verbunden ist.

## Claims

1. Integrated circuit for generating a reset signal, having the following features:
- the integrated circuit has connections for a first and a second supply potential (VDD_{X}, VSS),
- there is provided an inverter circuit (I1), which is arranged in terms of the supply voltage between a first circuit node (VA) of the entire circuit and the connection for the second supply potential (VSS),
- the input of the inverter circuit (I1) is connected to a second circuit node (VB) and the output of the said inverter circuit forms a third circuit node (VC),
- arranged between the connections for the first and the second supply potential (VDD_{X}, VSS) is an initialisation circuit (Init) having an output which forms the second circuit node (VB) and at which, when the first supply potential (VDD_{X}) is connected, a potential is produced which has a maximum value predetermined by the dimensioning of the initialisation circuit (Init),
- a transistor (T3) of a first conduction type is arranged with its source-drain path between the second circuit node (VB) and the connection for the second supply potential (VSS), the gate of which transistor is connected to the third circuit node (VC),
characterized
in that arranged between the connections for the first and the second supply potential (VDD_{X}, VSS) is a serial RC network (RC), having a resistive (R1) and a capacitive (C) component, between which the first circuit node (VA) is arranged, the voltage across the capacitive component (C) forming the supply voltage for the inverter circuit (I1),
and in that the third circuit node (VC) is an input of an inverter (I2), which is arranged in terms of the supply voltage between the connections for the first and the second supply potential (VDD_{X}, VSS) and at the output of which, which forms the fourth circuit node (VD) of the entire circuit, the reset signal is produced during operation.

2. Integrated circuit according to Claim 1, characterized in that arranged downstream of the fourth circuit node (VD) is a delay circuit (DLY), which, during operation, emits at its output (PWRON), with a delay, a second edge which follows a first edge of the reset signal.

3. Integrated circuit according to Claim 1 or 2, characterized in that the initialization circuit (Init) contains at least one non-reactive resistor (R2) which is arranged between the connection for the first supply potential (VDDₓ) and the second circuit node (VB).

4. Integrated circuit according to Claim 3, characterized in that the initialization circuit (Init) contains a transistor (T5) of a second conduction type opposite to the first conduction type, which transistor is arranged between the non-reactive resistor (R2) and the second circuit node (VB) and the gate of which transistor is connected to the third circuit node (VC).

5. Integrated circuit according to one of Claims 1, 2 and 3, characterized in that
- the initialization circuit (Init) contains two transistors (T4, T5) of a second conduction type opposite to the first conduction type, the source-drain paths of which transistors are connected in series with one another and which transistors are arranged between the connection for the first supply potential (VDD_{X}) and the second circuit node (VB), if appropriate in series with the non-reactive resistor (R2),
- the gate of one transistor (T4) of the series-connected transistors (T4, T5) is connected to the connection for the second supply potential (VSS),
- the gate of the other transistor (T5) of the series-connected transistors (T4, T5) is connected to the third circuit node (VC).

6. Integrated circuit according to one of the preceding claims, characterized in that the initialization circuit (Init) contains one diode (D) or at least two series-connected diodes (D1, D2), which is/are arranged between the second circuit node (VB) and the connection for the second supply potential (VSS).

7. Integrated circuit according to Claim 6, characterized in that the diodes (D; D1, D2) are MOS transistors, the gates of which are connected to the respectively associated drain.

8. Integrated circuit according to one of the preceding claims, characterized in that the inverter circuit (I1) contains at least one CMOS inverter (T1+T2) having one p-channel transistor (T1) and having one n-channel transistor (T2).

9. Integrated circuit according to Claim 8, characterized in that the substrate of the p-channel transistor (T1) is connected either to the first circuit node (VA) or, via a high resistance (R), to the connection for the first supply potential (VDDₓ).

## Revendications

1. Circuit intégré servant à produire un signal de remise à l'état initial, présentant les caractéristiques suivantes :
- le circuit intégré comporte des bornes pour les premier et second potentiels d'alimentation (VDDₓ, VSS),
- il est prévu un circuit inverseur (I1), qui est disposé, du point de vue de la tension d'alimentation, entre le premier noeud (VA) de l'ensemble du circuit et la borne pour le second potentiel d'alimentation (VSS),
- l'entrée du circuit inverseur (I1) est reliée à un second noeud (VB) du circuit et sa sortie forme un troisième noeud (VC) du circuit,
- entre les bornes pour les premier et second potentiels d'alimentation (VDDₓ, VSS) est disposé un circuit d'initialisation (Init) comportant une sortie, qui forme le second noeud (VB) du circuit et sur laquelle est présent, lors de l'application du premier potentiel d'alimentation (VDDₓ), un potentiel possédant une valeur maximale prédéterminée par le dimensionnement du circuit d'initialisation (Init),
- entre le second noeud (VB) et la borne pour le second potentiel d'alimentation (VSS) est disposée la voie source
- drain d'un transistor (T3) possédant un premier type de conduction et dont la grille est reliée au troisième noeud (VC) du circuit,
caractérisé par le fait
qu'entre les bornes pour les premier et second potentiels d'alimentation (VDDₓ,VSS) est disposé un réseau RC série (RC), comportant un composant ohmique (R1) et un composant capacitif (C), entre lesquels est disposé le premier noeud (VA) du circuit, la tension appliquée au composant capacitif (C) formant la tension d'alimentation pour le circuit inverseur (I1),
et que le troisième noeud (VC) du circuit forme l'entrée d'un inverseur (I2), qui, du point de vue de la tension d'alimentation, est disposé entre les bornes pour les premier et second potentiels d'alimentation (VDDₓ, VSS), un signal de remise à l'état initial étant présent, en fonctionnement, à la sortie du circuit inverseur, qui constitue le quatrième noeud (VD) de l'ensemble du circuit.

2. Circuit intégré suivant la revendication 1, caractérisé par le fait qu'en aval du quatrième noeud (VD) du circuit est raccordé un circuit de raccordement (DLY), qui, en fonctionnement, délivre d'une manière retardée, à sa sortie (PWRON), un second flanc qui succède à un premier flanc du signal de remise à l'état initial.

3. Circuit intégré suivant la revendication 1 ou 2, caractérisé par le fait que le circuit d'initialisation (Init) comporte au moins une résistance ohmique (R2), qui est disposée entre la borne pour le premier potentiel d'alimentation (VDDₓ) et le second noeud (VB) du circuit.

4. Circuit intégré suivant la revendication 3, caractérisé par le fait que le circuit d'initialisation (Init) comporte un transistor (T5) possédant un second type de conduction opposé au premier type de conduction et qui est disposé entre la résistance ohmique (R2) et le second noeud (VB) du circuit et dont la grille est reliée au troisième noeud (VC) du circuit.

5. Circuit intégré suivant l'une des revendications 1, 2 ou 3, caractérisé par le fait que
- le circuit d'initialisation (Init) comporte deux transistors (T4,T5), dont les voies source-drain sont branchées en série et qui possèdent un second type de conduction opposé au premier type de conduction et qui sont disposés entre la borne pour le premier potentiel d'alimentation (VDDₓ) et le second noeud (VB) du circuit, et ce en étant éventuellement en série avec la résistance ohmique (R2),
- la grille de l'un (T4) des transistors (T4,T5) branchés en série, est reliée à la borne pour le second potentiel d'alimentation (VSS), et
- la grille de l'autre (T5) des transistors (T4,T5) branchés en série est reliée au troisième noeud (VC) du circuit.

6. Circuit intégré suivant l'une des revendications précédentes, caractérisé par le fait que le circuit d'initialisation (Init) possède une diode (D) ou au moins deux diodes (D1,D2) branchées en série, qui est/sont disposée(s) entre le second noeud (VB) du circuit et le second potentiel d'alimentation (VSS).

7. Circuit intégré suivant la revendication 6, caractérisé par le fait que les diodes (D;D1,D2) sont des transistors MOS, dont les grilles sont reliées au drain respectivement associé.

8. Circuit intégré suivant l'une des revendications précédentes, caractérisé par le fait que le circuit inverseur (I1) possède au moins un inverseur CMOS (T1+T2) comportant un transistor (T1) à canal p et un transistor (T2) à canal n.

9. Circuit intégré suivant la revendication 8, caractérisé par le fait que le substrat du transistor (T1) à canal p, est relié soit au premier noeud (VA) du circuit, soit, selon une liaison à forte valeur ohmique (R), à la borne pour le premier potentiel d'alimentation (VDDₓ).
